# EUROPEAN PATENT APPLICATION

(11) **EP 4 831 995 A2**
(43) Date of publication of application: **28.10.2026**
(21) Application number: 26204806.9
(22) Date of filing: 08.01.2025
(51) Int. Cl.: G11C 29/00

(54) **MEMORY SYSTEM AND REPAIR OPERATION METHOD THEREOF**

(30) Priority: 24.05.2024 KR 20240068126
(62) Document number(s) of the earlier application(s) in accordance with Art. 76 EPC: 25150681.2 / 4 654 195
(71) Applicant: Samsung Electronics Co., Ltd., Suwon-si, Gyeonggi-do 16677 (KR)
(72) Inventor: BAEK, Seungbum, 16677 Suwon-si (KR); PARK, Sungcheol, 16677 Suwon-si (KR)
(74) Representative: Marks & Clerk LLP

(57) **Abstract**

A memory system includes a memory cell array including a memory cell group having a plurality of memory cells, and a redundancy memory cell group having a plurality of redundancy memory cells, each of the plurality of memory cells having a retention time equal to or greater than a preset refresh period for the memory cell array; a test circuit that determines a retention time of each of the plurality of memory cells and the plurality of redundancy memory cells, and determines whether each of the plurality of memory cells satisfies a repair condition based on the determined retention time; and a repair circuit that repairs a first memory cell that has a minimum retention time among the plurality of memory cells using one of the plurality of redundancy memory cells, in response to the test circuit determining that the first memory cell satisfies a repair condition.

## Description

### BACKGROUND

The present disclosure relates to memory systems and repair operation methods thereof, and more particularly to memory systems that repair a memory cell using a redundancy memory cell when it is determined that the memory cell satisfies a repair condition, and repair operation methods thereof.

Semiconductor memories are key components that store data in computer systems, and include multiple memory cells. The memory cells function to store data, and each memory cell has a physical position that can store data bits. The performance of some memory cells may be degraded due to defects, physical damage, etc. in a manufacturing process.

The refresh operation of the memory cell array can be performed based on the memory cells having degraded performance, but the refresh operation can be unnecessary for other memory cells of the memory cell array. Therefore, there is a need for a memory device and a repair method that can solve these problems.

The information described above is intended to improve understanding of the background of the present disclosure, and may include information that does not constitute the related art.

### SUMMARY

In order to solve one or more problems described above and/or other problems not explicitly described herein, some example embodiments of the present disclosure provide a memory system and a repair operation method thereof.

The problems to be solved by the present disclosure are not limited to those described above, and other problems not mentioned can be clearly understood by those skilled in the art from the description of the disclosure below.

Some example embodiments of the inventive concepts provide a memory system that includes a memory cell array and a redundancy memory cell group, the memory cell group including a plurality of memory cells and the redundancy memory cell group including a plurality of redundancy memory cells, each of the plurality of memory cells having a retention time equal to or greater than a preset refresh period for the memory cell array; a test circuit that determines the retention time of each of the plurality of memory cells and a retention time of the plurality of redundancy memory cells, and determines whether each of the plurality of memory cells satisfies a repair condition based on the determined retention time; and a repair circuit that repairs a first memory cell that has a first retention time that is a minimum retention time from among the plurality of memory cells using one of the plurality of redundancy memory cells, in response to the test circuit determining that the first memory cell satisfies the repair condition.

Some example embodiments further provide a memory system that includes a memory cell array including a memory cell group and a redundancy memory cell group, the memory cell group including a plurality of memory cells and the redundancy memory cell group including a plurality of redundancy memory cells; a repair circuit that repairs at least some of the plurality of memory cells using at least some of the plurality of redundancy memory cells, so that a weak cell of the plurality of memory cells having a retention time less than a minimum period is repaired and each of the plurality of memory cells has a retention time equal to or greater than a preset refresh period for the memory cell array; and a test circuit that determines the retention time of each of the plurality of memory cells and a retention time of each of the plurality of redundancy memory cells, and determines whether each of the plurality of memory cells satisfies a repair condition based on the determined retention time. In response to determination that one or more memory cells of the plurality of memory cells satisfy the repair condition and a retention time of at least some of available redundancy memory cells in the redundancy memory cell group is longer than a retention time of each of the one or more memory cells, the repair circuit repairs the one or more memory cells using the at least some of the available redundancy memory cells, the one or more memory cells including a memory cell having a minimum retention time from among the plurality of memory cells. The repair condition is a condition that the retention time of each of the one or more memory cells is less than a threshold time that is longer than the minimum period.

Some example embodiments still further provide a repair operation method of a memory system that includes determining, using a testing circuit, a retention time of each of a plurality of memory cells in a memory cell array, each of the plurality of memory cells having a retention time equal to or greater than a preset refresh period for the memory cell array; determining, using the testing circuit based on the determined retention time, whether a memory cell that has a minimum retention time from among the plurality of memory cells satisfies a repair condition; and repairing, using a repairing circuit, the memory cell using one of a plurality of redundancy memory cells included in the memory cell array, in response to determination that the memory cell satisfies the repair condition.

According to some example embodiments of the present disclosure, in the memory cell array including a plurality of memory cells including a repaired weak cell, one or more memory cells satisfying the repair condition can be repaired, thereby increasing the refresh period of the memory cell array. Accordingly, a service time for performing a read and write operation in the memory device can be increased. That is, the data bandwidth provided from the memory device can be improved.

The memory device reaching a threshold temperature should be operated with a refresh period shorter than the existing refresh period to ensure data integrity, but according to some example embodiments of the disclosure, the threshold temperature can be increased by repairing one or more memory cells satisfying the repair condition in the memory cell array including a plurality of memory cells including a repaired weak cell. That is, the memory device can be used up to the threshold temperature higher than a preset threshold temperature without adjusting the refresh period of the memory device.

Repairing a memory cell may comprise mapping the memory cell to a redundancy cell. Any data stored in the memory cell may be stored in the redundancy cell instead, and any data read from the memory cell may be read from the redundancy cell instead. That is, read and/or write operations that previously would have been directed to the memory cell may be directed to the redundancy cell. The repair operation may therefore replace the weak memory cell with a redundancy cell that has a longer retention time. This can therefore allow data integrity to be maintained whilst avoiding a reduction in the refresh period. After a memory cell has been repaired, the refresh period may be increased. This can increase the data bandwidth by reducing the frequency of refresh operations.

The effects that can be obtained through the present disclosure are not limited to those described above. Technical effects not mentioned will be clearly understood by those skilled in the art from the description of the present disclosure described below.

### BRIEF DESCRIPTION OF THE DRAWINGS

FIG. 1 is a block diagram illustrating a memory system according to some example embodiments of the inventive concepts;
FIG. 2 is a diagram illustrating a test circuit and a repair circuit connected to the memory device;
FIG. 3 is a diagram illustrating a memory interface;
FIG. 4 is a diagram illustrating an internal structure of a bank;
FIG. 5 is a diagram illustrating a detailed configuration of the memory cell array;
FIG. 6 is a diagram provided to explain repairing between memory cell groups;
FIG. 7 is a diagram provided to explain repairing between bit lines;
FIG. 8 is a diagram provided to explain repairing between a part of the bit line;
FIG. 9 is a diagram provided to explain repairing between memory cells;
FIG. 10 shows graphs provided to explain a process of calculating a retention time of a memory cell;
FIG. 11 is a flowchart illustrating a method for calculating a retention time of the memory cell;
FIG. 12 illustrates an example in which a bit written in each of a plurality of memory cells changes over time;
FIG. 13 is a diagram illustrating the retention times calculated for the plurality of memory cells in the memory cell group;
FIG. 14 is a graph showing the retention times of FIG. 13 in chronological order;
FIG. 15 is a diagram illustrating an operation in which a weak cell is repaired according to FIGS. 13 and 14;
FIG. 16 is a diagram illustrating an operation in which a memory cell satisfying the repair condition is repaired according to FIGS. 13 and 14;
FIG. 17 is a flowchart illustrating a repair operation method of a memory system;
FIG. 18 is a diagram illustrating an example of implementation of a semiconductor package; and
FIG. 19 is a cross-sectional view of a semiconductor package.

### DETAILED DESCRIPTION

In the present disclosure, a "memory cell" and a "cell" may refer to the same object and may be used interchangeably. For example, a "redundancy cell" may refer to a redundancy memory cell, and a "weak cell" may refer to a weak memory cell.

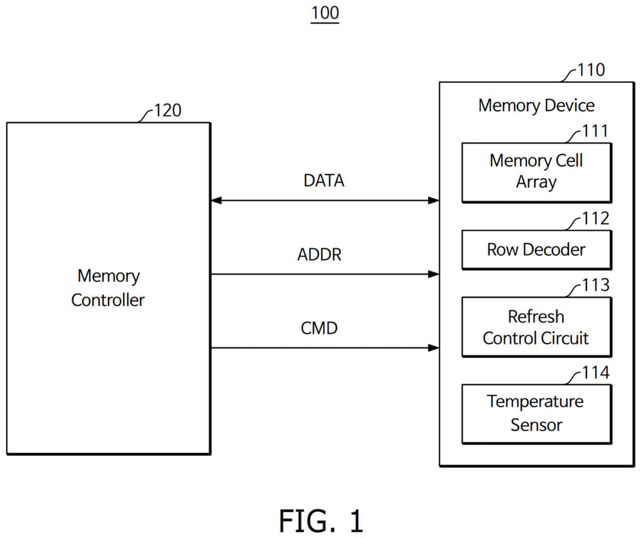

Hereinafter, some example embodiments of the present disclosure will be described with reference to FIGS. 1 to 19. The same reference numerals may refer to the same components throughout the description.

FIG. 1 is a block diagram illustrating a memory system. Referring to FIG. 1, a memory system 100 may include a memory device 110 and a memory controller 120.

The memory device 110 may be implemented with DRAM, but is not limited thereto. For example, the memory device 110 may correspond to Double Data Rate Synchronous Dynamic Random Access Memory (DDR SDRAM), Low Power Double Data Rate (LPDDR) SDRAM, Graphics Double Data Rate (GDDR) SDRAM, Rambus Dynamic Random Access Memory (RDRAM), etc. Alternatively, the memory device 110 may also be implemented with Static DRAM (SDRAM), high bandwidth memory (HBM), or Processor-In-Memory (PIM).

The memory device 110 may also be implemented with nonvolatile memory devices. For example, the memory device 110 may be implemented with flash memory or resistive memory such as Phase change RAM (PRAM), Magnetic RAM (MRAM), and Resistive RAM (RRAM).

The memory device 110 may include a memory cell array 111, a row decoder 112, a refresh control circuit 113, and a temperature sensor 114.

The memory cell array 111 may include a plurality of word lines, a plurality of bit lines, and a plurality of memory cells. The plurality of memory cells may be respectively connected to each of the plurality of word lines and the plurality of bit lines, and may be defined by a plurality of rows and a plurality of columns. In some example embodiments, the rows may be defined by the word lines, and the columns may be defined by the bit lines. The plurality of memory cells may be implemented with non-volatile memory capable of storing data regardless of whether power is supplied or not, or volatile memory capable of storing data while power is supplied, and may store data by physically fuse-cutting with a laser or by electrical programming.

The refresh control circuit 113 may transmit an address of a row to be refreshed, of a plurality of rows, to the row decoder 112. The row decoder 112 may perform a refresh operation on the row to be refreshed. A refresh operation may be performed periodically according to a refresh period. Each refresh operation may rewrite data stored in the data cells. This can be implemented to correct for charge leakage over time. A pre-set refresh period may set for the memory cell array 111. The refresh period applied to the memory cell may be adjusted from a pre-set value, for instance, based on temperature, or based on one or more repair operations (discussed below).

The temperature sensor 114 may measure a temperature of at least a part of the memory device 110. For example, the temperature sensor 114 may measure the temperature of the memory cell array 111. The temperature information measured by the temperature sensor 114 may be transmitted to the memory controller 120.

The memory controller 120 may provide a signal to the memory device 110 to control the operation of the memory device 110. The signal may include a command CMD and an address ADDR. In some example embodiments, the memory controller 120 may provide the command CMD and the address ADDR to the memory device 110 to access the memory cell array 111 and control memory operations such as read and write. Data may be transmitted from the memory cell array 111 to the memory controller 120 according to the read operation, and data may be transmitted from the memory controller 120 to the memory cell array 111 according to the write operation.

The command CMD may include an activation command, a read and write command, and a refresh command. In some example embodiments, the command CMD may further include a precharge command. The refresh command may be a command for performing a refresh operation in the memory cell array 111.

In response to the memory device 110 receiving the refresh command, the refresh operation may be performed in the memory cell array 111 for each preset refresh period.

The refresh period of the memory cell array 111 may be determined based on the shortest retention time of the retention times of memory cells (e.g., excluding memory cells repaired using redundancy cells) used for actual memory operations in the memory cell array 111. For example, the refresh period may be determined to be equal to or less than a minimum retention time of the retention times of the memory cells used for actual memory operation in the memory cell array 111. In response to repairing a memory cell that has a minimum retention time among the memory cells used for actual memory operation, the memory controller 120 may set the refresh period of the memory cell array 111 to a refresh period longer than a preset refresh period. For instance, the refresh period may be increased in response to repairing a memory cell that has a minimum retention time.

The memory controller 120 may determine the refresh period of the memory cell array 111 based on a temperature measured by the temperature sensor 114. For example, in response to an increase in the temperature measured by the temperature sensor 114, the memory controller 120 may set the refresh period of the memory cell array to the refresh period shorter than the preset refresh period. For example, if it is determined that the temperature measured by the temperature sensor is equal to or greater than a threshold temperature, the memory controller 120 may set the refresh period of the memory cell array 111 to a refresh period shorter than the preset refresh period. If the temperature of the memory cell array 111 increases, the charge holding capacity of the memory cell array 111 decreases, increasing the risk of data loss, and accordingly, the refresh operation may be performed more frequently than the existing refresh period so as to ensure data integrity. The memory controller 120 may increase the threshold temperature, in response to repairing a memory cell that has a minimum retention time among the memory cells used for actual memory operation in the memory cell array 111.

In some example embodiments, the memory controller 120 may access the memory device 110, in response to a request from a host outside the memory system 100. The memory controller 120 may communicate with the host using various protocols.

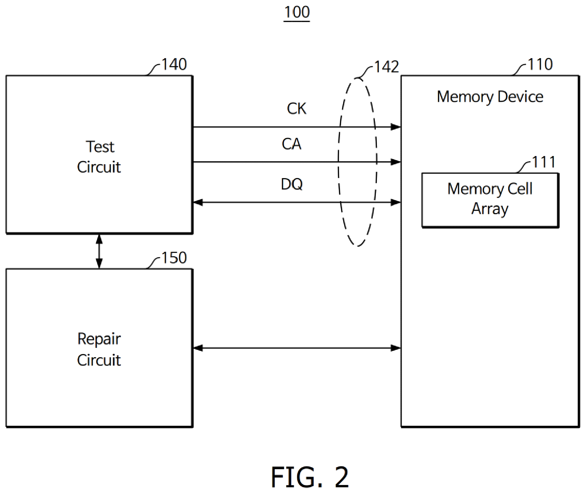

FIG. 2 is a diagram illustrating a test circuit 140 and a repair circuit 150 connected to the memory device 110. Each of the test circuit 140 and the repair circuit 150 may be implemented in hardware and/or software.

The test circuit 140 may perform a test operation on the memory device 110. For example, the test circuit 140 may perform a test operation on the memory cells included in the memory cell array 111. The test circuit 140 may store specific data in the memory cell array 111 and read the data, and determine pass or fail of the test operation according to whether the read data is the same as the specific data.

The test circuit 140 may test the memory device 110 through a channel 142. The channel 142 may include a bus that physically or electrically connects the test circuit 140 and the memory device 110, through which clock CK, command and address CA, and data DQ may be transmitted and received between the test circuit 140 and the memory device 110.

The test circuit 140 may measure changes in voltage, current, frequency and other parameters, under various driving conditions for the memory device 110 and test whether the range of the change falls within a desired (and/or alternatively predetermined) acceptable range.

The test circuit 140 may provide a command to the memory device 110 to test a memory operation. Non-limiting examples of the memory commands may include, for example, a timing command for controlling timing of various operations, an access command for accessing the memory, a read command for performing a read operation and a write command for performing a write operation, a mode register write and read command for performing a mode register write and read operation, a post package repair (PPR) command, etc.

In the test, if the write command and a related address (e.g. write location) are provided to the memory device 110 by the test circuit 140, the memory device 110 may receive the write command and the related address and perform the write operation of writing the data received from the test circuit 140 to a memory location corresponding to the related address. Likewise, if the read command and a related address (e.g. read location) are provided to the memory device 110 by the test circuit 140, the memory device 110 may receive the read command and the related address and perform a read operation of outputting the read data from a memory location corresponding to the related address.

The repair circuit 150 may repair a faulty cell (e.g., a weak cell) in the memory cell array 111 with a redundancy cell. For example, the repair circuit 150 may repair a weak cell detected through an EDS (electrical die sorting) test and/or a package/module/mount test of the memory device 110 after the semiconductor manufacturing process of the memory device 110. The repair circuit 150 may repair memory cells that exhibit unstable voltage values upon application of voltage, or that are physically damaged or detected to be faulty on the connected data path, etc. The repair circuit 150 may cause the address of the redundancy cell to be selected instead of the address of the detected weak cell of the memory cell array 111.

The repair circuit 150 may repair the weak cell in the memory cell array 111 such that the minimum specifications (e.g., Joint Electron Device Engineering Council (JEDEC) specifications, etc.) required for the memory cell array 111 may be satisfied. For instance, a minimum refresh period may be defined for the memory cell array 111 (e.g. based on minimum specifications set out by JEDEC). A weak cell with retention time less than a preset refresh period may be repaired such that the memory cell array 111 may be refreshed with the minimum refresh period (e.g., 64 ms) required for the memory cell array 111 or longer. The preset refresh period may be equal to or greater than the minimum refresh period. For instance, the refresh period may be adjusted, but the memory system 111 may be configured such that the refresh period may not be lowered below the minimum period.

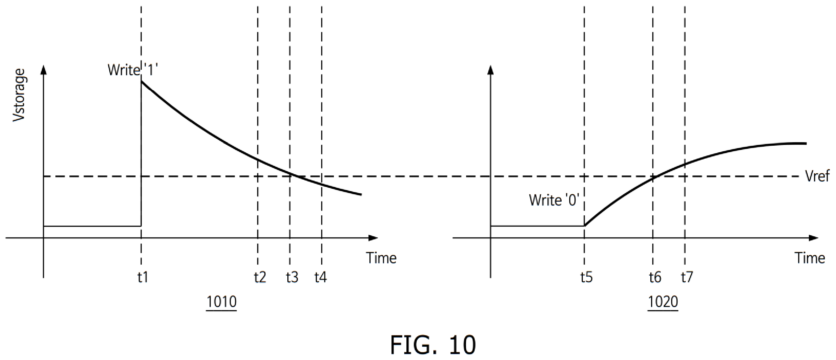

The repair circuit 150 may repair memory cells with retention time equal to or greater than a preset refresh period for the memory cell array 111 (e.g., the minimum refresh period required for the memory cell array 111). For example, if the test circuit 140 determines that a specific memory cell in the memory cell array 111 satisfies a repair condition, the repair circuit 150 may repair the memory cell using the redundancy cell. The test circuit 140 may calculate (e.g., determine) a retention time of a specific memory cell, and determine whether the corresponding memory cell satisfies a repair condition or not based on the calculated (e.g., determined) retention time. Through this, the refresh period of the memory cell array 111 may be increased, thereby improving the performance of the memory device 110. This will be described below in detail with reference to FIGS. 10 to 15.

The repair circuit 150 may store redundancy mapping information that indicates an address (e.g., row address and/or column address) of the repaired memory cell has been repaired with a redundancy address (e.g., redundancy row address and/or redundancy column address).

The test circuit 140 and the repair circuit 150 are illustrated as being connected to the memory device 110 from the outside of the memory device 110, but some example embodiments are not limited thereto. For example, the test circuit 140 and/or the repair circuit 150 may be included in the memory device 110.

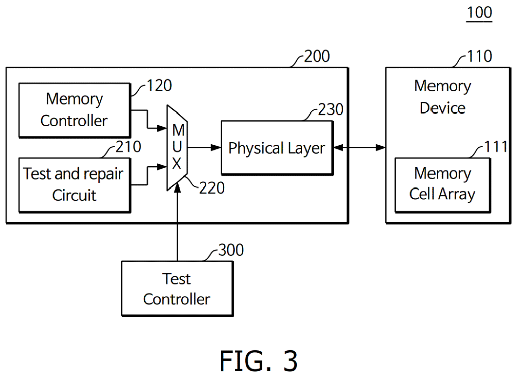

FIG. 3 is a diagram illustrating a memory interface 200. The memory interface 200 may include the memory controller 120, a test and repair circuit 210, a multiplexer 220, and a physical layer 230. The memory interface 200 may be connected to the memory device 110 through the physical layer 230.

The test and repair circuit 210 may correspond to the test circuit 140 and the repair circuit 150 of FIG. 2. For example, the test and repair circuit 210 may be implemented by combining the test circuit 140 and the repair circuit 150 of FIG. 2 as one circuit. Alternatively, the test functionality and the repair functionality may be implemented through a test circuit and a (separate) repair circuit.

Either the memory controller 120 or the test and repair circuit 210, selected using the multiplexer 220, may be connected to the memory device 110 through the physical layer 230. That is, the memory device 110 may perform any one of a general memory operation performed using the memory controller 120, and a test and repair operation performed using the test and repair circuit 210.

A test controller 300 may transmit a signal to the multiplexer 220 to select either the memory controller 120 or the test and repair circuit 210 as a configuration to be connected to the memory device 110.

The test and repair circuit 210 is illustrated as a separate configuration from the memory controller 120, but some example embodiments are not limited thereto. For example, the test and repair circuit 210 may be included in the memory controller 120, and the multiplexer 220 may be omitted from the memory interface 200. Alternatively, the test and repair circuit 210 may be configured separately as the test circuit 140 and the repair circuit 150 of FIG. 2, and any one of the test circuit 140 and the repair circuit 150 may be included in the memory controller 120.

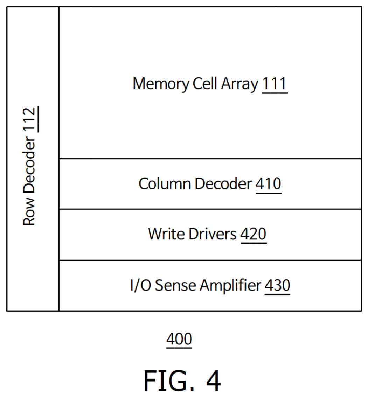

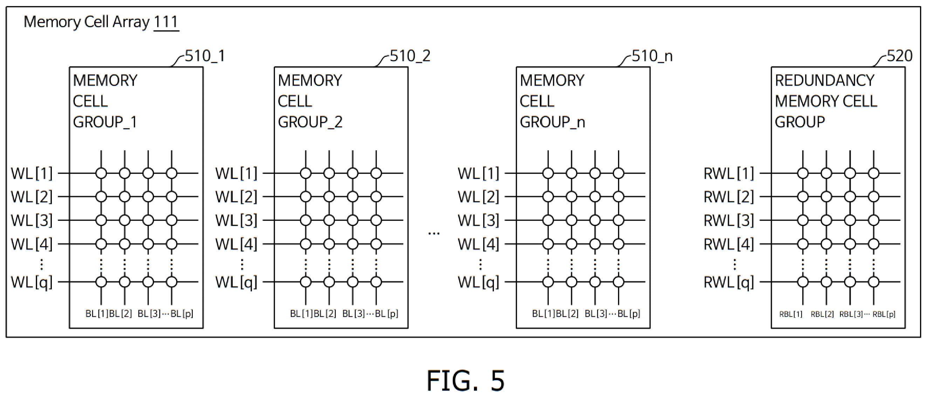

FIG. 4 is a diagram illustrating an internal structure of a bank 400, and FIG. 5 is a diagram illustrating a detailed configuration of the memory cell array 111. The bank 400 may include the memory cell array 111, the row decoder 112, a column decoder 410, a write driver 420, and an I/O sense amplifier 430.

Referring to FIG. 5, the memory cell array 111 may include first to n-th memory cell groups 510_1 to 510_n (where, n is a natural number of 2 or more), each including a plurality of memory cells, and a redundancy cell group 520 including a plurality of redundancy cells. Alternatively, the memory cell array 111 may include one memory cell group and/or a plurality of redundancy cell groups. That is, the memory cell array 111 may include one or more memory cell groups and one or more redundancy cell groups.

The first to n-th memory cell groups 510_1 to 510_n may be configured in the same or similar arrangement to each other. The redundancy cell group 520 may be configured in the same or similar arrangement as any one of the first to n-th memory cell groups 510_1 to 510_n. Although FIG. 5 illustrates that the first to n-th memory cell groups 510_1 to 510_n and the redundancy cell group 520 include the same number (q, where q is any natural number) of word lines and the same number (p, where p is any natural number) of bit lines, this is for convenience of description and some example embodiments are not limited thereto. Each of the first to n-th memory cell groups 510_1 to 510_n and the redundancy cell group 520 may include any number of word lines and bit lines. It is illustrated that there are separate word lines WL[1] ~ WL[q], RWL[1] ~ RWL[q] and bit lines BL[1] ~ BL[p], RBL[1] ~ RBL[p] of the memory cell array 111 for each group, but some example embodiments are not limited thereto, and two or more groups may share the word lines and/or bit lines with each other.

The memory cells and the redundancy cells in the memory cell array 111 may be connected to the row decoder 112 through a plurality of word lines arranged in a row direction, and may be connected to the column decoder 410 through bit lines arranged in a column direction.

The writing or reading of the first to n-th memory cell groups 510_1 to 510_n and the redundancy cell group 520 may be performed with the writing or reading method of a general semiconductor memory device.

For example, the row decoder 112 connected to the memory cells and the redundancy cells through a plurality of word lines may decode the row address signal input from an address controller, and the decoded row address signal may activate the word lines WL[1] ~ WL[q], RWL[1] ~ RWL[q] of the memory cell array.

Likewise, the column decoder 410 connected to the memory cells and the redundancy cells through the plurality of bit lines may decode the column address signal. The decoded column address signal may perform a selection operation on the bit lines BL[1] ~ BL[p], RBL[1] ~ RBL[p] of the memory cell array through a column select line.

During a write operation, the write driver 420 and the I/O sense amplifier 430 may transmit write data to a memory cell selected by the row decoder 112 and the column decoder 410. Likewise, during a read operation, the write driver 420 and the I/O sense amplifier 430 may detect data stored in the memory cell selected by the row decoder 112 and the column decoder 410.

The bank 400 may further include a control logic (e.g., control logic circuit). The control logic may decode a command received from the outside (e.g., the memory controller 120 of FIG. 1).

The memory cell array 111 may be refreshed in response to the control logic decoding the refresh command. The bank 400 may be in an inactive state while the memory cell array 111 is being refreshed. Accordingly, as the refresh period of the memory cell array 111 is increased, the activation time of the bank 400 may increase, thereby improving the efficiency of the memory device.

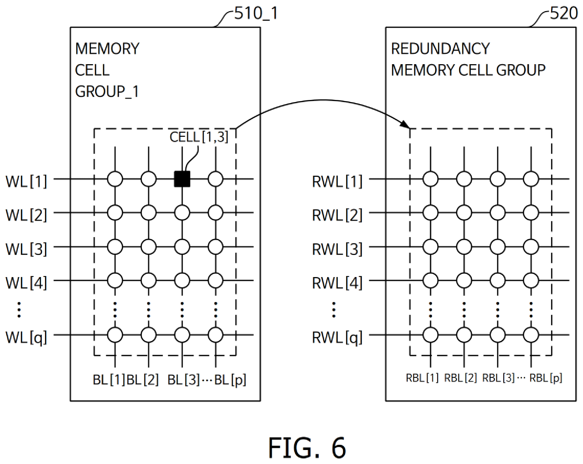

Some of the memory cells in the first to n-th memory cell groups 510_1 to 510_n may be repaired with corresponding redundancy cells in the redundancy cell group 520. Data to be written or read to or from the repaired memory cells may be written or read to or from the redundancy cells. Examples in which the memory cell is repaired with the redundancy cell will be described below in detail with reference to FIGS. 6 to 9.

FIGS. 6 to 9 are diagrams illustrating a method for repairing some of the memory cells with the redundancy cells. For convenience of description, an example of repairing a memory cell in the first memory cell group 510_1 is illustrated and described, but some example embodiments are not limited thereto. The repair operation described with reference to FIGS. 6 to 9 may be performed using a repair circuit (e.g., 150 of FIG. 2).

FIG. 6 is a diagram provided to explain repairing between memory cell groups. For example, if there is a memory cell CELL[1,3] to be repaired in the first memory cell group 510_1, the first memory cell group 510_1 may be repaired with the redundancy cell group 520. That is, if there is the memory cell CELL[1,3] to be repaired in the first memory cell group 510_1, an address signal of the first memory cell group 510_1 including the memory cell CELL[1,3] to be repaired may be determined to be an address signal for the redundancy cell group 520 and processed accordingly. For instance, an address for the memory cell CELL[1,3] to be repaired may be mapped to an address for a redundancy cell.

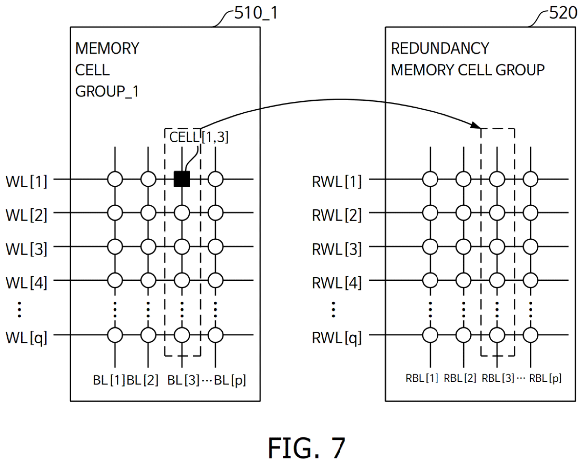

FIG. 7 is a diagram provided to explain repairing between bit lines. For example, if the memory cell CELL[1,3] to be repaired is connected to a third bit line BL[3] in the first memory cell group 510_1, the memory cells connected to the third bit line BL[3] may be repaired with the cells connected to one bit line RBL[3] of the bit lines connected to the redundancy cell group 520. That is, the column address signal for the third bit line BL[3] may be determined to be a column address signal for one bit line of the bit lines connected to the redundancy cell group 520 and processed accordingly. For instance, a column address for the bit line comprising the memory cells to be repaired may be mapped to a column address for a bit line in the redundancy cell group 520.

Additionally or alternatively, if the memory cell CELL[1,3] to be repaired is connected to a first word line WL[1], the memory cells connected to the first word line WL[1] may be repaired with cells connected to one word line RWL[1] of the word lines connected to the redundancy cell group 520. For instance, a row address for the word line comprising the memory cells to be repaired may be mapped to a row address for a word line in the redundancy cell group 520.

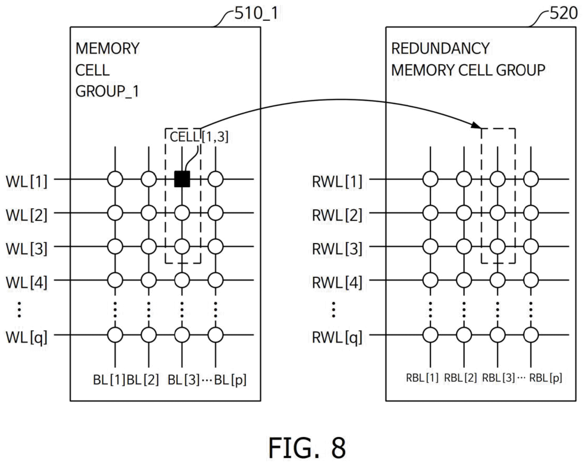

FIG. 8 is a diagram provided to explain repairing between a part of the bit line (e.g., a segment of the bit line). One bit line may be divided into two or more segments to which at least one memory cell is connected. For example, if the memory cell CELL[1,3] to be repaired in the first memory cell group 510_1 is connected to the third bit line BL[3], some of the cells connected to the third bit line BL[3] that include the memory cell CELL[1,3] to be repaired may be repaired with some of the cells connected to one of the bit lines connected to the redundancy cell group 520. That is, the column address signal for the third bit line BL[3] may be determined to be a column address signal of one of the bit lines connected to the redundancy cell group 520, and at least some bits of the row address may be determined to be the word lines connected to the redundancy cell group 520 such that a repair between segments may be performed. For instance, the column address for the bit line comprising the memory cell(s) to be repaired may be mapped to a column address of one of the bit lines connected to the redundancy cell group 520, and at least some bits of the row address (e.g. some row addresses, corresponding to the memory cell(s) to be repaired) may be mapped to word lines connected to the redundancy cell group 520.

Additionally or alternatively, if the memory cell CELL[1,3] to be repaired is connected to the first word line WL[1], a part of the memory cells connected to the first word line WL[1] including the memory cell CELL[1,3] to be repaired may be repaired as a part of the cells connected to one word line RWL[1] of the word lines connected to the redundancy cell group 520. For instance, the row address for the word line comprising the memory cell(s) to be repaired may be mapped to a row address of one of the word lines connected to the redundancy cell group 520, and at least some bits of the column address (e.g. some column addresses, corresponding to the memory cell(s) to be repaired) may be mapped to bit lines connected to the redundancy cell group 520.

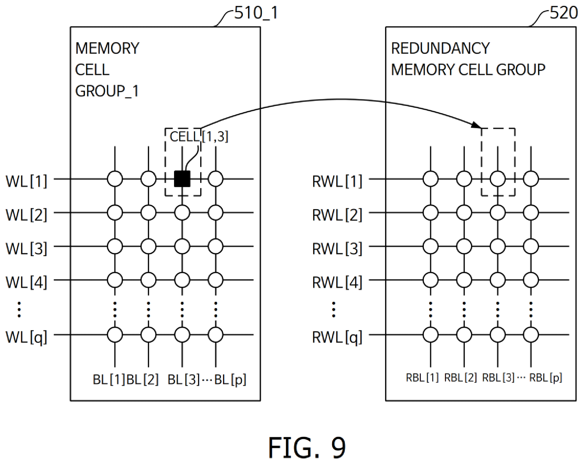

FIG. 9 is a diagram provided to explain repairing between memory cells. For example, if there is the memory cell CELL[1,3] to be repaired in the first memory cell group 510_1, the memory cell CELL[1,3] to be repaired may be repaired with a redundancy cell. That is, the column address signal and the row address signal for the memory cell CELL[1,3] to be repaired may be determined to be a column address signal and a row address signal for the redundancy cell and processed accordingly such that the repair operation may be processed in units of one memory cell. For instance, the column address and the row address for the memory cell CELL[1,3] to be repaired may be mapped to a column address and a row address for the redundancy cell and processed accordingly such that the repair operation may be processed in units of one memory cell.

Unlike the examples illustrated in FIGS. 5 to 9, internal redundancy cell groups for performing repairs inside each memory cell group may be provided in each memory cell group. For example, the first memory cell group 510_1 may include an internal redundancy cell group therein, and a plurality of redundancy bit lines corresponding to the internal redundancy cell group may be arranged. In some example embodiments, the memory cell to be repaired for each memory cell group may be repaired first with the internal redundancy cell group provided therein, and the subsequent repair may be performed with the redundancy cell group 520 if there is another memory cell to be repaired.

A retention time according to leakage characteristics of the plurality of memory cells in the memory cell group 510_1 and the plurality of redundancy cells in the redundancy cell group 520 may be utilized for determining whether each of the plurality of memory cells in the memory cell group 510_1 satisfies a repair condition, and the memory cell satisfying the repair condition may be repaired. An example of calculating (e.g., determining) the retention time of the memory cell and the redundancy cell will be described in detail with reference to FIGS. 10 to 14.

FIG. 10 shows graphs 1010 and 1020 provided to explain a process of calculating (e.g., calculating) a retention time of a memory cell. The retention time of the memory cell may be calculated using a test circuit (e.g., 140 of FIG. 2).

The first graph 1010 and the second graph 1020 may represent leakage characteristics of a specific memory cell (or, a redundancy cell) in the memory cell array.

The first graph 1010 and the second graph 1020 represent a change over time (Time) of the voltage stored (Vstorage) in the memory cell. For example, the first graph 1010 represents a change in voltage after writing a bit '1' to the memory cell, and the second graph 1020 represents a change in voltage after writing a bit '0' to the memory cell. A reference voltage Vref is a voltage for comparison with a voltage stored in the memory cell, in which, if the voltage stored in the memory cell is higher than the reference voltage Vref, bit '1' may be stored in the memory cell, and if the voltage stored in the memory cell is lower than the reference voltage Vref, bit '0' may be stored in the memory cell.

A first time point t1 in the first graph 1010 may represent a time at which a write operation of writing a bit '1' is performed. After the first time point t1, the voltage stored in the memory cell may decrease over time due to the generation of the leakage current.

In order to calculate the retention time of the memory cell, a read operation of the memory cell may be performed at a second time point t2. Since the read value at the second time point t2 is the same as the bit '1' written at the first time point t1, the retention time of the memory cell may be calculated to be longer than the time elapsed from the first time point t1 to the second time point t2. The second time point t2 may be a time point after at least a preset refresh period of the memory cell array elapses from the first time point t1. The preset refresh period may be equal to or greater than the minimum period required for the memory cell array.

The read operation may be performed at a third time point t3 in response to the read value at the second time point t2 being the same as the bit '1' written at the first time point t1. Since the read value at the third time point t3 is the same as the bit '1' written at the first time point t1, the retention time of the memory cell may be calculated to be longer than the time elapsed from the first time point t1 to the third time point t3.

The read operation may be performed at a fourth time point t4 in response to the read value at the third time point t3 being the same as the bit '1' written at the first time point t1, or in response to the read value at the third time point t3 being the same as the read value at the previous read time point, that is, at the second time point t2. Since the read value at the fourth time point t4 is different from the bit '1' written at the first time point t1 and is different from the read value at the previous time point, that is, at the third time point t3, the retention time of the memory cell may be calculated to be shorter than the time elapsed from the first time point t1 to the fourth time point t4. That is, the retention time of the memory cell may be calculated (e.g., determined) as a time between (t3 - t1) and (t4 - t1). Accordingly, read operations may be performed periodically until the data stored in the memory cell changes (e.g. the voltage stored in the memory cell passes the reference voltage), at which point the retention time may be determined (e.g. may be determined to be between the time to the most recent read operation, and the time to the preceding read operation).

Likewise, the retention time of the memory cell may be calculated by writing the bit '0' to the memory cell and performing a read operation.

In the second graph 1020, a fifth time point t5 may represent a time at which a write operation of writing a bit '0' is performed. After the fifth time point t5, the voltage stored in the memory cell may increase over time.

The read operation of the memory cell may be performed at a sixth time point t6 to calculate the retention time of the memory cell. Since the read value at the sixth time point t6 is the same as the bit '0' written at the fifth time point t5, the retention time of the memory cell may be calculated to be longer than the time elapsed from the fifth time point t5 to the sixth time point t6. The sixth time point t6 may be a time point after more than a preset refresh period of the memory cell array elapses from the fifth time point t5. The preset refresh period may be equal to or greater than the minimum period required for the memory cell array.

The read operation may be performed at a seventh time point t7 in response to the read value at the sixth time point t6 being the same as the bit '1' written at the fifth time point t5. Since the read value at the seventh time point t7 is different from the bit '0' written at the fifth time point t5 or the read value at the sixth time point t6, the retention time of the memory cell may be calculated to be shorter than the time elapsed from the fifth time point t5 to the seventh time point t7. That is, the retention time of the memory cell may be calculated (e.g., determined) as a time between (t6 - t5) and (t7 - t5).

Alternatively, the read operation for calculating the retention time of the memory cell may be sequentially performed starting from the latest time point since the write operation. For example, in the first graph 1010, a write operation of writing a bit '1' may be performed at the first time point t1, and a read operation of the memory cell may be performed at the fourth time point t4. Because the read value at the fourth time point t4 is different from the bit '1' written at the first time point t1, the retention time of the memory cell may be calculated to be shorter than the time elapsed from the first time point t1 to the fourth time point t4.

The read operation may be performed at the third time point t3 in response to the read value at the fourth time point t4 being different from the bit '1' written at the first time point t1. This may occur in a subsequent operation (e.g. after writing the bit again into the memory cell). In response to the read value of the third time point t3 being the same as the bit '1' written at the first time point t1 or different from the read value at the previous read time point, that is, at the fourth time point t4, the retention time of the memory cell may be calculated to be longer than the time elapsed from the first time point t1 to the third time point t3.

Likewise, in the second graph 1020, a write operation of writing a bit '0' may be performed at the fifth time point t5, and a read operation of the memory cell may be performed at the seventh time point t7. Because the read value at the seventh time point t7 is different from the bit '0' written at the fifth time point t5, the retention time of the memory cell may be calculated to be shorter than the time elapsed from the fifth time point t5 to the seventh time point t7.

The read operation may be performed at the sixth time point t6 in response to the read value at the seventh time point t7 being different from the bit '0' written at the fifth time point t5. This may occur in a subsequent operation (e.g. after writing the bit again into the memory cell). In response to the read value at the sixth time point t6 being the same as the bit '0' written at the fifth time point t5 or different from the read value at the previous read time point, that is, at the seventh time point t7, the retention time of the memory cell may be calculated to be longer than the time elapsed from the fifth time point t5 to the sixth time point t6.

For the same memory cell, the leakage characteristics may be different between when a bit '0' is written and when a bit '1' is written. That is, the tendency of the charge stored in the memory cell to change over time may be different between when the bit '0' is written and when the bit '1' is written, and thus the retention time may be calculated differently.

The first time point t1 and the fifth time point t5 may represent a time point at which the write operation is performed, rather than a fixed time point. For example, a write operation may be performed again before increasing or decreasing the interval between the write operation and the read operation and performing a read operation, and in some example embodiments the corresponding time point may be set as the first time point t1 or the fifth time point t5 again. For example, the read operation at the third time point t3 may not be performed immediately after the read operation at the second time point t2 is performed. Instead, the write operation at the first time point t1 may be performed again, and then the read operation at the third time point t3 may be performed.

In light of the above, one or more read operations may be performed after one or more write operations. By comparing the data read to the data written, the retention time (the time for the data within the memory cell to change) may be determined.

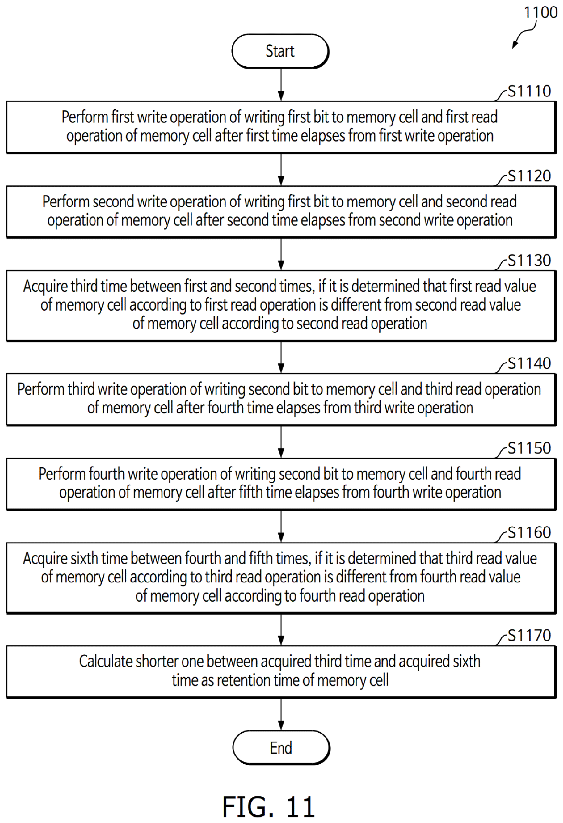

FIG. 11 is a flowchart illustrating a method 1100 for calculating (e.g., determining) a retention time of the memory cell. The method 1100 may be performed using a test circuit (e.g., 140 of FIG. 2). The method 1100 may be performed on the memory cell and the redundancy cell.

The test circuit may perform a first write operation of writing a first bit (e.g., bit '1') to the memory cell for which the retention time is to be calculated (e.g., determined), and perform a first read operation of the memory cell after a first time elapses from the first write operation, at S1110. The first time may be longer than a preset refresh period (e.g., 64 ms) of the memory cell array including the memory cell.

The test circuit may perform a second write operation of writing the first bit to the memory cell, and perform a second read operation of the memory cell after a second time elapses from the second write operation, at S1120. The second time may be longer than a preset refresh period of the memory cell array including the memory cell. For example, the second time may be different from (e.g. longer or shorter than) the first time by a unit time (e.g., 1 ms or 2 ms). A unit time may be a predefined amount of time (e.g. a predefined change in time).

If it is determined that a first read value of the memory cell according to the first read operation is different from a second read value of the memory cell according to the second read operation, the test circuit may acquire (e.g., determine) a third time between the first time and the second time, at S1130. For example, if the first read value is different from the first bit and the second read value is the same as the first bit, or if the first read value is the same as the first bit and the second read value is different from the first bit, the test circuit may acquire the third time between the first time and the second time as the retention time of the memory cell or as a candidate retention time of the memory cell.

The test circuit may perform a third write operation of writing the second bit to the memory cell, and perform a third read operation of the memory cell after a fourth time elapses from the third write operation, at S1140. The second bit may be a bit (e.g., bit '0') opposite to the first bit. The fourth time may be any time that is longer than the preset refresh period of the memory cell array including the memory cell.

Likewise, the test circuit may perform a fourth write operation of writing the second bit to the memory cell, and perform a fourth read operation of the memory cell after a fifth time elapses from the fourth write operation, at S1150. The fifth time may be longer than the preset refresh period of the memory cell array including the memory cell. For example, the fifth time may be different from (e.g. longer or shorter than) the fourth time by a unit time.

If it is determined that the third read value of the memory cell according to the third read operation is different from the fourth read value of the memory cell according to the fourth read operation, the test circuit may acquire a sixth time between the fourth time and the fifth time, at S1160. For example, if the third read value is different from the second bit and the fourth read value is the same as the second bit, or if the third read value is the same as the second bit and the fourth read value is different from the second bit, the test circuit may acquire (e.g., determine) the sixth time between the fourth time and the fifth time as the retention time of the memory cell or as a candidate retention time of the memory cell.

The test circuit may calculate (e.g., determine) a shorter one of the acquired third time and the acquired sixth time as the retention time of the memory cell, at S1170. That is, the retention time of the memory cell may be the shorter of a first time by which a bit '1' changes to '0', and a second time by which a bit '0' changes to '1'.

The flowchart illustrated in FIG. 11 and the above description are merely examples and may be implemented differently in some examples. For example, one or more operations in the flowchart may be omitted, the order of operations may be changed, one or more operations may be performed in parallel, or one or more operations may be repeatedly performed multiple times.

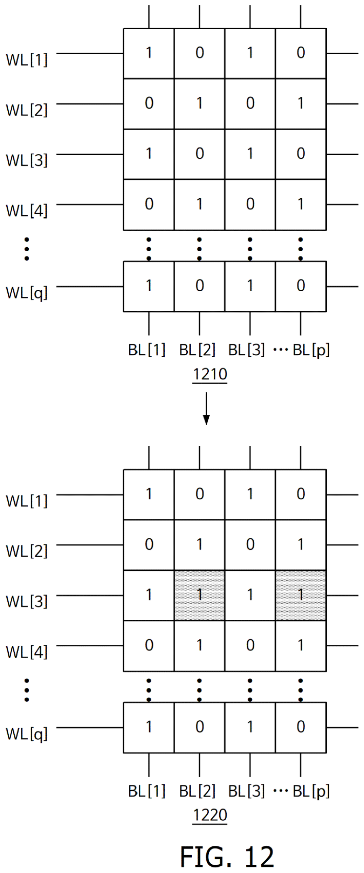

FIG. 12 illustrates an example in which a bit written in each of a plurality of memory cells changes over time. The memory cell group of FIG. 12 may represent each of the first to n-th memory cell groups 510_1 to 510_n of FIG. 5 or the redundancy cell group 520, but some example embodiments are not limited thereto.

For each of the plurality of memory cells in the memory cell group, the retention time may be calculated according to the method described above with reference to FIGS. 10 and 11. The retention time may be calculated for all memory cell arrays (or banks) in the memory device, sequentially in units of memory cells, bit lines, word lines, memory cell groups, or memory cell arrays, and may be calculated in parallel for one or more memory cells in the unit.

A first operation 1210 illustrates an example in which a write operation of a specific bit is performed on each of the plurality of memory cells in the memory cell group. As illustrated in FIG. 12, different bits may be written to each of the plurality of memory cells. Alternatively, the same bit ('0' or '1') may be written to all of the plurality of memory cells.

A second operation 1220 illustrates an example in which a read operation is performed on each of the plurality of memory cells in the memory cell group after a desired (and/or alternatively predetermined) time elapses from the write operation. It can be seen that the bits written to some cells CELL[3,2] and CELL[3,p] are flipped over time. The retention time of the cell with the flipped written bit may be calculated to be equal to or less than a time elapsed from the write operation to the read operation. On the other hand, the retention time of the other cells without the flipped bit may be calculated to exceed the time elapsed from the write operation to the read operation.

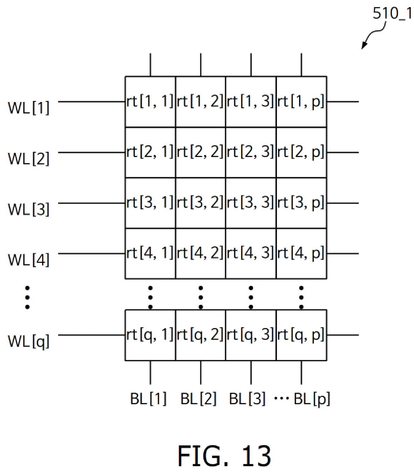

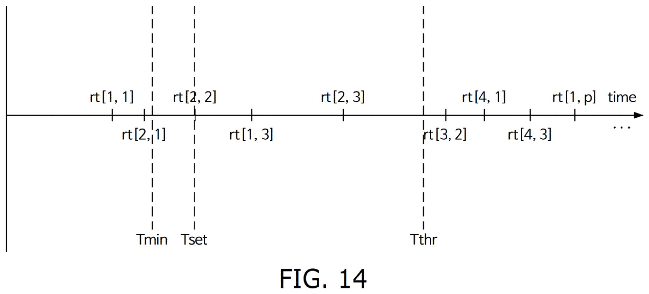

FIG. 13 is a diagram illustrating the retention times calculated for the plurality of memory cells in the memory cell group 510_1, and FIG. 14 is a graph showing the retention times of FIG. 13 in chronological order. For example, the retention time of a memory cell CELL[i,j] at a point at which the i-th word line and the j-th bit line cross each other is expressed as rt[i,j] (where, i is from 1 to q, j is from 1 to p, where p and q are natural numbers of 2 or more).

Referring to FIG. 14, the memory cells CELL[1,1], CELL[2,1] with retention times rt[1,1], rt[2,1] less than a preset refresh period (Tset) or a minimum refresh period (Tmin) required for the memory cell array (e.g., minimum period in the JEDEC specification) are weak cells, and a primary repair may be performed using redundancy cells. That is, any cell that has a retention time that is less than the preset refresh period (Tset) or the minimum refresh period (Tmin) may be defined as a weak cell. The term "weak" is compared to other cells (e.g. "strong" cells) that have retention times that are greater than or equal to the preset refresh period or the minimum refresh period.

The refresh period of the memory cell array may be set to be equal to or less than the minimum retention time of the retention times of the memory cells used for actual memory operations in the memory cell array. Therefore, with the weak cell repaired, the redundancy cell corresponding to the weak cell is operated instead, and accordingly, the minimum retention time of the memory cell used for the actual memory operation in the memory cell array may be increased, and the refresh period (Tset) of the memory cell array may be set to be equal to or greater than the minimum period (Tmin) required for the memory cell array.

A secondary repair may be performed on a memory cell satisfying a repair condition. A memory cell with inferior leakage characteristic may be further repaired. For example, memory cells CELL[2,2], CELL[1,3], CELL[2,3] with retention time less than a threshold time (Tthr) may be further repaired. These memory cells may have retention times that are less than the threshold time Thr and greater than or equal to the refresh period Tset. By also repairing memory cells other than weak cells, the minimum retention time of the retention times of the memory cells used for actual memory operation in the memory cell array may be increased to the threshold time (Tthr) or more, and the refresh period of the memory cell array may be set to the threshold time (Tthr) or more.

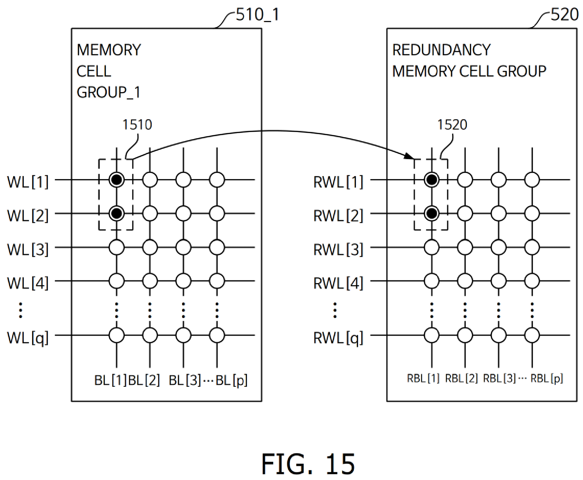

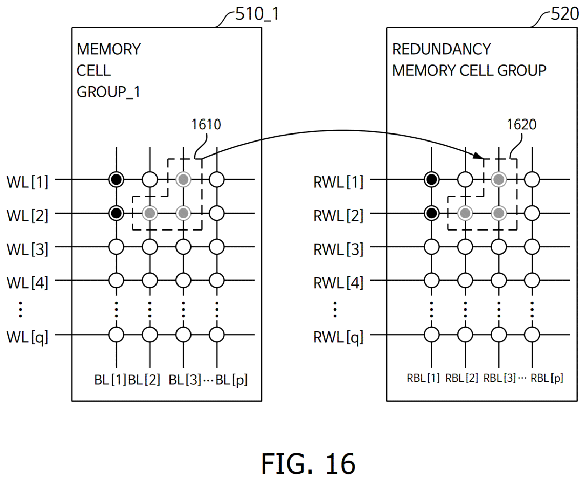

FIG. 15 is a diagram illustrating an operation in which a weak cell 1510 is repaired according to FIGS. 13 and 14, and FIG. 16 is a diagram illustrating an operation in which a memory cell 1610 satisfying the repair condition is repaired according to FIGS. 13 and 14. The repair operations of FIGS. 15 and 16 may be performed using a repair circuit (e.g., 150 of FIG. 2).

The weak cell 1510 and the memory cell 1610 in the memory cell group 510_1 may be repaired using available redundancy cells 1520 and 1620 in the redundancy cell group 520. The retention time of each of the available redundancy cells 1520 and 1620 may be longer than the retention time of the cell to repair.

Alternatively, the weak cell 1510 and the memory cell 1610 may be repaired according to some example embodiments and described with reference to FIGS. 6 to 8. The shortest one of the retention times of the redundancy cells for repairing the memory cells according to FIGS. 6 to 8 may be longer than the shortest one of the retention times of the memory cells to repair. For example, if the bit line BL[1] connected to the weak cell 1510 is replaced by a bit line RBL[1] in the redundancy cell group 520, the shortest one of the retention times of the redundancy cells on the bit line RBL[1] of the redundancy cell group 520 may be longer than the shortest one of the retention times of the memory cells on the bit line BL[1] connected to the weak cell 1510.

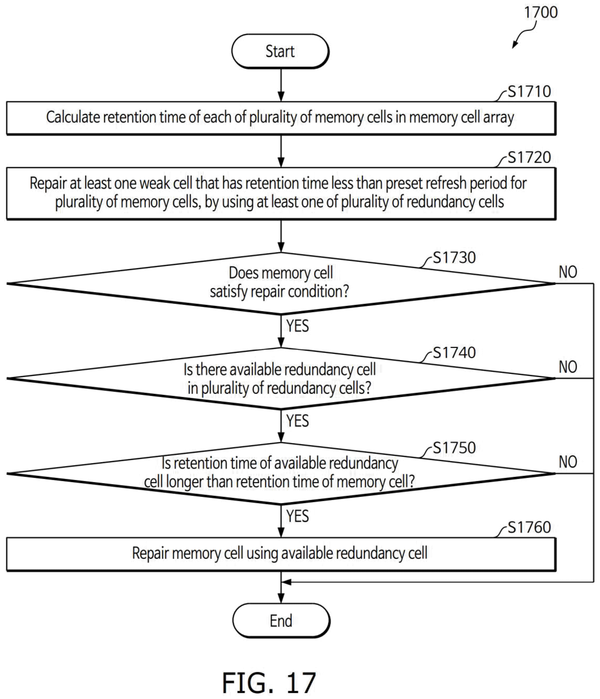

FIG. 17 is a flowchart illustrating a repair operation method 1700 of a memory system. The repair operation method 1700 may be performed using the test circuit 140 and the repair circuit 150 of FIG. 2. The repair operation method 1700 may be performed in units of memory cell arrays or banks. For example, upon termination of the repair operation method 1700 performed on one memory cell array or bank, the repair operation method 1700 may be performed on another memory cell array or bank, and may be repeatedly performed on all memory cell arrays in the memory device. Alternatively, the repair operation method 1700 may be performed in parallel for the plurality of memory cell arrays.

The test circuit may calculate (e.g., determine) the retention time of each of the plurality of memory cells included in the memory cell array, at S1710. The test circuit may also calculate (e.g., determine) the retention time of each of the plurality of redundancy cells included in the memory cell array.

The repair circuit may repair at least one cell with a retention time less than a preset refresh period (e.g. at least one weak cell), of the plurality of memory cells, by using at least one of the plurality of redundancy cells, at S1720. The preset refresh period may be equal to or greater than the minimum period required for the memory cell array.

The test circuit may determine whether there are any memory cells (e.g. within the memory cell array or bank) that satisfy the repair condition, at S1730. For example, the repair condition may be a condition that the retention time of the memory cell is less than a threshold time longer than the preset refresh period.

The threshold time may be set based on a target refresh period of the memory cell array. For example, a longer threshold time may be set as the target refresh period increases so that the number of memory cells to be repaired may increase and the refresh period of the memory cell array may increase. If there is no memory cell satisfying the repair condition in the memory cell array, the repair operation method 1700 for the corresponding memory cell array may be terminated.

If it is determined that a specific memory cell satisfies the repair condition, the test circuit may determine whether there is an available redundancy cell, at S1740. The available redundancy cell may refer to a redundancy cell that is not yet used for the repair of the other memory cells. A search may be done within the redundancy cell group included in the corresponding memory cell array to find out whether there is the available redundancy cell or not. If it is determined that there is an available redundancy cell, the repair circuit may repair the memory cell using the available redundancy cell. If it is determined that there is no available redundancy cell, the repair operation method 1700 for the corresponding memory cell array may be terminated.

If it is determined that there are available redundancy cell(s), the test circuit may determine whether the retention time(s) of the available redundancy cell(s) is longer than the retention time of the memory cell, at S1750. If it is determined that the retention time of the available redundancy cell is longer than the retention time of the first memory cell, the repair circuit may repair the memory cell using the available redundancy cell. That is, if there is an available redundancy cell that has a longer retention time than the memory cell, then the repair circuit may repair the memory cell using the available redundancy cell. That is, the repair operation may be performed using a redundancy cell having better leakage characteristic than the memory cell. On the other hand, if the retention time of the available redundancy cell is shorter than the shortest one of the retention times of the memory cell satisfying the repair condition, the repair operation method 1700 for the memory cell array may be terminated because, even if the repair is performed, the minimum retention time of the memory cell used for actual memory operation in the corresponding memory cell array is shortened. For instance, if there are no available redundancy cells having a longer retention time than the memory cell, then the repair operation method 1700 for the memory cell may be terminated.

Alternatively, if there is an available redundancy cell with retention time longer than the retention time of the memory cell satisfying the repair condition, the repair circuit may repair the memory cell using the available redundancy cell, at S1760. Steps S1740-S1760 may be performed for each memory cell satisfying the repair condition. In operations at S1740 and S1750, if the number of available redundancy cells is less than the number of memory cells satisfying the repair condition, the memory cells satisfying the repair condition may be repaired in the order of shorter retention time to longer retention time (e.g. in order of increasing retention time). For example, after the memory cell is repaired using the available redundancy memory cell at S1760, the memory controller 120 may control the memory device 110 to write data into the repaired memory cell. Accuracy of the stored data may thus be improved, and the refresh period of the memory cell array may be increased improving performance and reliability of the memory device 110.

The flowchart illustrated in FIG. 17 and the above description are merely examples and may be implemented differently in some other example embodiments. For example, one or more operations in the flowchart may be omitted, the order of operations may be changed, one or more operations may be performed in parallel, or one or more operations may be repeatedly performed multiple times.

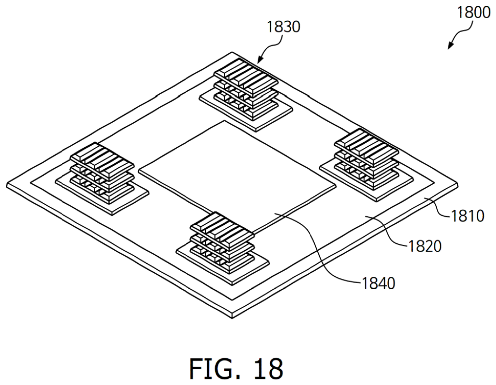

FIG. 18 is a diagram illustrating an example of implementation of a semiconductor package 1800.

Referring to FIG. 18, the semiconductor package 1800 may include a stacked memory device 1830 and a host die 1840. The stacked memory device 1830 and the host die 1840 may be stacked on an interposer 1820, and the interposer 1820 may be stacked on a package substrate 1810. The semiconductor package 1800 may transmit and receive signals to and from other external packages or semiconductor devices through a solder ball (not illustrated) attached to a lower portion of the package substrate 1810.

Each of the stacked memory devices 1830 may be implemented based on a high-bandwidth memory (HBM) standard. However, aspects are not limited thereto, and each of the stacked memory devices 1830 may be implemented based on a graphics double data rate (GDDR), a hybrid memory cube (HMC), or a wide I/O standard.

The stacked memory device 1830 may include a plurality of core dies and a buffer die. At least one of a plurality of core dies may include a memory device (e.g., the memory device 110 of FIG. 1) illustrated and described with reference to the previous drawings.

The host die 1840 may include at least one processor, such as a Central Processing Unit (CPU), Application Processor (AP), Graphic Processing Unit (GPU), Neural Processing Unit (NPU), System on Chip (SoC), Tensor Processing Unit (TPU), Vision Processing Unit (VPU), Image Signal Processor (ISP), and Digital Signal Processor (DSP).

The host die 1840 may include a memory controller (e.g., the memory controller 120 of FIG. 1) that controls the stacked memory device 1830. The host die 1840 may transmit and receive signals to and from a corresponding stacked memory device through the memory controller. Alternatively, the memory controller may be included in the stacked memory device 1830.

The memory controller may control the overall operation of the stacked memory device 1830. The memory controller 1820 may transmit signals for controlling the stacked memory device 1830 to the stacked memory device 1830 through a physical layer.

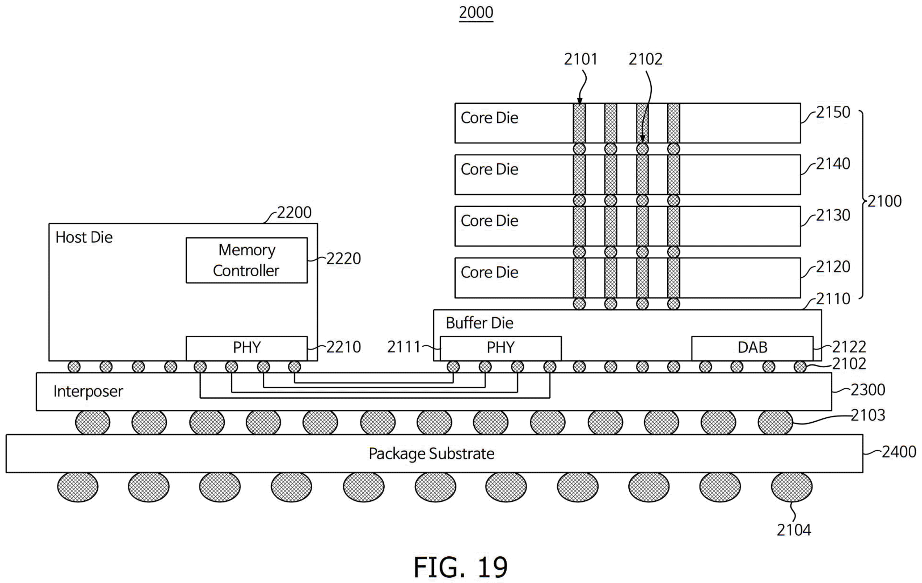

FIG. 19 is a cross-sectional view of a semiconductor package 2000. The semiconductor package 2000 of FIG. 19 may include a stacked memory device 2100, a host die 2200, an interposer 2300, and a package substrate 2400. The stacked memory device 2100, the host die 2200, the interposer 2300, and the package substrate 2400 of FIG. 19 may correspond to the stacked memory device 1830, the host die 1840, the interposer 1820, and the package substrate 1810 of FIG. 18, respectively. Although FIG. 19 illustrates that the host die 2200 is disposed adjacent a side surface of the stacked memory device 2100, some example embodiments are not limited thereto. For example, the host die 2200 may be disposed under the stacked memory device 2100.

Core dies 2120 to 2150 may each include a memory cell array. A buffer die 2110 may include a physical layer 2111 and a direct access region (DAB) 2122. The physical layer 2111 may be electrically connected to a physical layer 2210 of the host die 2200 through the interposer 2300. The stacked memory device 2100 may receive signals from the host die 2200 or transmit signals to the host die 2200 through the physical layer 2111. The physical layer 2111 may include interface circuits of the buffer die 2110.

The direct access region 2122 may provide an access path to test the stacked memory device 2100 without passing through the host die 2200. The direct access region 2122 may include a conductive means (e.g., a port or a pin) capable of directly communicating with an external test and/or repair device. The test signal and data received through the direct access region 2122 may be transmitted to the core dies 2120 to 2150 through TSVs. Data read from the core dies 2120 to 2150 for testing the core dies 2120 to 2150 may be transmitted to the test device through the TSVs and the direct access region 2122. Accordingly, direct access test and repair may be performed on the core dies 2120 to 2150.

The buffer die 2110 and the core dies 2120 to 2150 may be electrically connected to each other through the TSVs 2101 and bumps 2102. The buffer die 2110 may receive signals provided for each channel from the host die 2200 through the bumps 2102 allocated for each channel. For example, the bumps 2102 may be micro-bumps.

The host die 2200 may execute applications supported by the semiconductor package 2000 using the stacked memory device 2100.

The host die 2200 may include the physical layer 2210 and a memory controller 2220. Alternatively, the memory controller 2220 may be separately disposed outside the host die 2200 or may be included in the buffer die 2110.

The physical layer 2210 may include input and output circuits for transmitting and receiving signals to and from the physical layer 2111 of the stacked memory device 2100. The host die 2200 may provide various signals to the physical layer 2111 through the physical layer 2210. The signals provided to the physical layer 2111 may be transmitted to the core dies 2120 to 2150 through interface circuits and the TSVs 2101 of the physical layer 2111. The host die 2200 may include a test and repair circuit (e.g., the test and repair circuit 210). Similarly to FIG. 3, a multiplexer may be included in the host die 2200, so that the memory controller 2220 or the test and repair circuit may be connected to the physical layer 2210 of the host die 2200 according to a control signal.

The memory controller 2220 may control the overall operation of the stacked memory device 2100. The memory controller 2220 may transmit signals for controlling the stacked memory device 2100 to the stacked memory device 2100 through the physical layer 2210. The memory controller 2220 may correspond to the memory controller 120 of FIG. 1.

The interposer 2300 may connect the stacked memory device 2100 to the host die 2200. The interposer 2300 may connect the physical layer 2111 of the stacked memory device 2100 to the physical layer 2210 of the host die 2200, and may provide physical paths formed with conductive materials. Accordingly, the stacked memory device 2100 and the host die 2200 may be stacked on the interposer 2300 to transmit and receive signals to and from each other.

Bumps 2103 may be attached to an upper portion of the package substrate 2400, and a solder ball 2104 may be attached to a lower portion thereof. For example, the bumps 2103 may be flip-chip bumps. The interposer 2300 may be stacked on the package substrate 2400 through the bumps 2103. The semiconductor package 2000 may transmit and receive signals to and from other external packages or semiconductor devices through the solder ball 2104. For example, the package substrate 2400 may be a printed circuit board (PCB).

One or more of the elements disclosed above may include or be implemented in processing circuitry such as hardware including logic circuits; a hardware/software combination such as a processor executing software; or a combination thereof. For example, the processing circuitry may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, an application-specific integrated circuit (ASIC), etc.

Embodiments are set out in the following clauses:
Clause 1. A memory system, comprising:
   a memory cell array comprising a memory cell group and a redundancy memory cell group, the memory cell group comprising a plurality of memory cells and the redundancy memory cell group comprising a plurality of redundancy memory cells;
   a repair circuit configured to repair at least some of the plurality of memory cells using at least some of the plurality of redundancy memory cells, so that a weak cell of the plurality of memory cells having a retention time less than a minimum period is repaired and each of the plurality of memory cells has a retention time equal to or greater than a preset refresh period for the memory cell array; and
   a test circuit configured to determine the retention time of each of the plurality of memory cells and a retention time of each of the plurality of redundancy memory cells, and determine whether each of the plurality of memory cells satisfies a repair condition based on the determined retention time, wherein
   in response to determination that one or more memory cells of the plurality of memory cells satisfy the repair condition and a retention time of at least some of available redundancy memory cells in the redundancy memory cell group is longer than a retention time of each of the one or more memory cells, the repair circuit is configured to repair the one or more memory cells using the at least some of the available redundancy memory cells, wherein the one or more memory cells comprise a memory cell having a minimum retention time from among the plurality of memory cells, and
   the repair condition is a condition that the retention time of each of the one or more memory cells is less than a threshold time that is longer than the minimum period.
Clause 2. A repair operation method of a memory system, comprising:
   determining, using a testing circuit, a retention time of each of a plurality of memory cells in a memory cell array, wherein each of the plurality of memory cells has a retention time equal to or greater than a preset refresh period for the memory cell array;
   determining, using the testing circuit based on the determined retention time, whether a memory cell that has a minimum retention time from among the plurality of memory cells satisfies a repair condition; and
   repairing, using a repair circuit, the memory cell using one of a plurality of redundancy memory cells of the memory cell array, in response to determination that the memory cell satisfies the repair condition.
Clause 3. The method according to Clause 2, further comprising repairing, before the determining the retention time of each of the plurality of memory cells, at least one weak cell of the plurality of memory cells using at least one of the plurality of redundancy memory cells, wherein the at least one weak cell has a retention time less than the preset refresh period, and
   the preset refresh period being equal to or greater than a minimum period required for the memory cell array.
Clause 4. The method according to Clause 2 or Clause 3, wherein the repairing comprises:
   determining whether there is an available redundancy memory cell among the plurality of redundancy memory cells; and
   repairing the memory cell using the available redundancy memory cell, in response to determination that the available redundancy memory cell is among the plurality of redundancy memory cells.
Clause 5. The method according to Clause 4, wherein the repairing the memory cell using the available redundancy memory cell comprises:
   determining whether a retention time of the available redundancy memory cell is longer than the retention time of the memory cell; and
   repairing the memory cell using the available redundancy memory cell, in response to determination that the retention time of the available redundancy memory cell is longer than the retention time of the memory cell.
Clause 6. A memory system, comprising:
   a memory cell array comprising a memory cell group and a redundancy memory cell group, the memory cell group comprising a plurality of memory cells and the redundancy memory cell group comprising a plurality of redundancy memory cells, wherein each of the plurality of memory cells has a retention time equal to or greater than a preset refresh period for the memory cell array;
   a test circuit configured to determine the retention time of each of the plurality of memory cells and a retention time of each of the plurality of redundancy memory cells, and determine whether each of the plurality of memory cells satisfies a repair condition based on the determined retention time; and
   a repair circuit configured to repair a first memory cell that has a first retention time that is a minimum retention time from among the plurality of memory cells using one of the plurality of redundancy memory cells, in response to the test circuit determining that the first memory cell satisfies the repair condition.
Clause 7. The memory system according to Clause 6, wherein
   the preset refresh period is equal to or greater than a minimum period required for the memory cell array, and
   the repair circuit is configured to repair a weak cell from among the memory cell array that has a retention time less than the preset refresh period.
Clause 8. The memory system according to Clause 6 or Clause 7, wherein
   the test circuit is configured to determine whether there is an available redundancy memory cell in the redundancy memory cell group, and
   the repair circuit is configured to repair the first memory cell using the available redundancy memory cell, in response to the test circuit determining that the available redundancy memory cell is in the redundancy memory cell group.
Clause 9. The memory system according to Clause 8, wherein
   the test circuit is configured to determine whether a retention time of the available redundancy memory cell is longer than the first retention time of the first memory cell, and
   the repair circuit is configured to repair the first memory cell using the available redundancy memory cell, in response to the test circuit determining that the retention time of the available redundancy memory cell is longer than the first retention time of the first memory cell.
Clause 10. The memory system according to any of Clauses 6-9, wherein the repair condition is a condition that the first retention time of the first memory cell is less than a threshold time that is longer than the preset refresh period, and
   the threshold time is set based on a target refresh period of the memory cell array.
Clause 11. The memory system according to any preceding of Clauses 6-10, further comprising:
   a temperature sensor configured to measure a temperature of at least a portion of a memory device comprising the memory cell array; and
   a memory controller configured to control the memory device, wherein
   in response to determination that the temperature measured by the temperature sensor is equal to or greater than a first threshold temperature, the memory controller is configured to set a refresh period of the memory cell array to be shorter than the preset refresh period, and
   in response to the first memory cell being repaired by the repair circuit, the memory controller is configured to set the first threshold temperature to a second threshold temperature, the second threshold temperature being greater than the first threshold temperature.
Clause 12. The memory system according to any of Clauses 6-11, further comprising a memory controller configured to control a memory device comprising the memory cell array, wherein
   the memory controller is configured to set a refresh period of the memory cell array to be longer than the preset refresh period, in response to the first memory cell being repaired by the repair circuit.
Clause 13. The memory system according to any of Clauses 6-12, wherein the repair circuit is configured to repair a part of the plurality of memory cells that includes the first memory cell, in response to determination that the first memory cell satisfies the repair condition, and
   the part of the plurality of memory cells includes a second memory cell on a same bit line or a same word line as the first memory cell.
Clause 14. The memory system according to Clause 13, wherein a shortest retention time from among the plurality of redundancy memory cells for repairing the part of the plurality of memory cells is longer than the first retention time of the first memory cell.
Clause 15. The memory system according to any of Clauses 6-14, wherein the test circuit is configured to
   perform a first write operation of writing a first bit to the first memory cell;
   perform a first read operation of the first memory cell after a first time elapses from the first write operation;
   perform a second write operation of writing the first bit to the first memory cell;
   perform a second read operation of the first memory cell after a second time elapses from the second write operation, wherein the first time and the second time are longer than the preset refresh period, and the second time is longer or shorter than the first time by a unit time; and
   acquire a third time between the first time and the second time, in response to determination that a first read value of the first memory cell according to the first read operation is different from a second read value of the first memory cell according to the second read operation.
Clause 16. The memory system according to Clause 15, wherein the test circuit is configured to
   perform a third write operation of writing a second bit to the first memory cell, the second bit being opposite the first bit;
   perform a third read operation of the first memory cell after a fourth time elapses from the third write operation;
   perform a fourth write operation of writing the second bit to the first memory cell;
   perform a fourth read operation of the first memory cell after a fifth time elapses from the fourth write operation, wherein the fourth time and the fifth time are longer than the preset refresh period, and the fifth time is longer or shorter than the fourth time by the unit time; and
   acquire a sixth time between the fourth time and the fifth time, in response to determination that a third read value of the first memory cell according to the third read operation is different from a fourth read value of the first memory cell according to the fourth read operation, wherein
   the test circuit is configured to determine a shorter one of the third time and the sixth time as the first retention time of the first memory cell.
Clause 17. A repair operation method of a memory system, comprising:
   determining, using a testing circuit, a retention time of each of a plurality of memory cells in a memory cell array, wherein each of the plurality of memory cells has a retention time equal to or greater than a preset refresh period for the memory cell array;
   determining, using the testing circuit based on the determined retention time, whether a memory cell that has a minimum retention time from among the plurality of memory cells satisfies a repair condition; and
   repairing, using a repair circuit, the memory cell using one of a plurality of redundancy memory cells of the memory cell array, in response to determination that the memory cell satisfies the repair condition.
Clause 18. The method according to Clause 17, further comprising repairing, before the determining the retention time of each of the plurality of memory cells, at least one weak cell of the plurality of memory cells using at least one of the plurality of redundancy memory cells, wherein the at least one weak cell has a retention time less than the preset refresh period, and
   the preset refresh period being equal to or greater than a minimum period required for the memory cell array.
Clause 19. The method according to Clause 17 or Clause 18, wherein the repairing comprises:
   determining whether there is an available redundancy memory cell among the plurality of redundancy memory cells; and
   repairing the memory cell using the available redundancy memory cell, in response to determination that the available redundancy memory cell is among the plurality of redundancy memory cells.
Clause 20. The method according to Clause 19, wherein the repairing the memory cell using the available redundancy memory cell comprises:
   determining whether a retention time of the available redundancy memory cell is longer than the retention time of the memory cell; and
   repairing the memory cell using the available redundancy memory cell, in response to determination that the retention time of the available redundancy memory cell is longer than the retention time of the memory cell.

## Claims

1. A memory system (100), comprising:
a memory cell array (111) comprising a memory cell group (510) and a redundancy memory cell group (520), the memory cell group comprising a plurality of memory cells and the redundancy memory cell group comprising a plurality of redundancy memory cells;
a test circuit (140) configured to:
determine the retention time of each of the plurality of memory cells and a retention time of each of the plurality of redundancy memory cells;
a repair circuit (150) configured to:
repair at least one memory cell that has a retention time less than a preset refresh period from among the plurality of memory cells using at least one of the plurality of redundancy memory cells;
a temperature sensor (114) configured to measure a temperature of at least a portion of a memory device (110) comprising the memory cell array; and
a memory controller (120) configured to control the memory device, wherein
in response to determination that the temperature measured by the temperature sensor is equal to or greater than a first threshold temperature, the memory controller is configured to set a refresh period of the memory cell array to be shorter than the preset refresh period, and
in response to the repair circuit repairing a first memory cell having a minimum retention time from among the plurality of memory cells, the memory controller is configured to set the first threshold temperature to a second threshold temperature, the second threshold temperature being greater than the first threshold temperature.

2. The memory system according to claim 1, wherein the preset refresh period is equal to or greater than a minimum period required for the memory cell array.

3. The memory system according to claim 1 or claim 2, wherein
the test circuit is configured to determine whether there is an available redundancy memory cell in the redundancy memory cell group, and
the repair circuit is configured to repair the first memory cell using the available redundancy memory cell, in response to the test circuit determining that the available redundancy memory cell is in the redundancy memory cell group.

4. The memory system according to claim 3, wherein
the test circuit is configured to determine whether a retention time of the available redundancy memory cell is longer than a first retention time of the first memory cell, and
the repair circuit is configured to repair the first memory cell using the available redundancy memory cell, in response to the test circuit determining that the retention time of the available redundancy memory cell is longer than the first retention time of the first memory cell.

5. The memory system according to any preceding claim, wherein
the memory controller is configured to set a refresh period of the memory cell array to be longer than the preset refresh period, in response to the first memory cell being repaired by the repair circuit.

6. The memory system according to any preceding claim, wherein
the repair circuit is configured to repair a part of the plurality of memory cells that includes the first memory cell, and
the part of the plurality of memory cells includes a second memory cell on a same bit line or a same word line as the first memory cell.

7. The memory system according to claim 6, wherein a shortest retention time from among the plurality of redundancy memory cells for repairing the part of the plurality of memory cells is longer than a first retention time of the first memory cell.

8. A repair operation method of a memory system, comprising:
determining (S1710), using a testing circuit (140), a retention time of each of a plurality of memory cells and each of a plurality of redundancy memory cells in a memory cell array (111);
repairing (S1720), using a repair circuit (150), at least one memory cell that has a retention time less than a preset refresh period using at least one of the plurality of redundancy memory cells of the memory cell array;
measuring, using a temperature sensor (114), a temperature of at least a portion of a memory device (110) comprising the memory cell array;
in response to determination that the temperature measured by the temperature sensor is equal to or greater than a first threshold temperature, setting, using a memory controller (120), a refresh period of the memory cell array to be shorter than the preset refresh period; and
in response to the repair circuit repairing a first memory cell having a minimum retention time from among the plurality of memory cells, setting, using the memory controller, the first threshold temperature to a second threshold temperature, the second threshold temperature being greater than the first threshold temperature.

9. The method according to claim 8, wherein the preset refresh period is equal to or greater than a minimum period required for the memory cell array.

10. The method according to claim 8 or claim 9, wherein the repairing of the first memory cell by the repair circuit comprises:
determining whether there is an available redundancy memory cell among the plurality of redundancy memory cells; and
repairing the first memory cell using the available redundancy memory cell, in response to determination that the available redundancy memory cell is among the plurality of redundancy memory cells.

11. The method according to claim 10, wherein repairing the first memory cell using the available redundancy memory cell comprises:
determining whether a retention time of the available redundancy memory cell is longer than the retention time of the first memory cell; and
repairing the first memory cell using the available redundancy memory cell, in response to determination that the retention time of the available redundancy memory cell is longer than the retention time of the first memory cell.
